# EUROPÄISCHE PATENTANMELDUNG

(11) **EP 0 953 657 A2**
(43) Veröffentlichungstag der Anmeldung: **03.11.1999**
(21) Anmeldenummer: 99107955.9
(22) Anmeldetag: 22.04.1999
(51) Int. Cl.: C23C 14/56

(54) **Vakuumbeschichtungsanlage**

(30) Priorität: 02.05.1998 DE 19819726
(71) Anmelder: Leybold Systems GmbH, 63450 Hanau (DE)
(72) Erfinder: Rick, Alfred, 63791 Karlstein (DE); Hoffmann, Josef, 63939 Wörth (DE); Michael, Klaus Dr., 63571 Gelnhausen (DE)

(57) **Zusammenfassung**

Vakuumbehandlungsanlage zum Aufbringen dünner Schichten auf Substrate (36,38,40,42) mit einer Transferkammer (5) und mehreren an dieser peripher angeordneten und mit dieser jeweils über eine gemeinsame Öffnung (27,29,31,33) zum Ein- und Ausschleusen der Substrate (36,38,40,42) verbundenen Behandlungskammern (6,8,10,12) und mit einer Handlingseinrichtung (24) zum Transport der Substrate (36,38,40,42) zwischen den Behandlungskammern (6,8,10,12), wobei die Handlingseinrichtung (24) mindestens einen Substrathalter (37,39,41,43) mit einem schwenk- und/oder rotierbaren Halteteil zur Aufnahme der Substrate (36,38,40,42) aufweist, mittels welchen die Substrate (36,38,40,42) in den Behandlungskammern (6,8,10,12) schwenk- und/oder rotierbar sind.

## Beschreibung

Die Erfindung betrifft eine Vakuumbehandlungsanlage, mittels welcher dünne, harte Schichten auf Substrate aufbringbar sind. Eine gattungsbildende Vakuumbehandlungsanlage umfaßt eine Transferkammer und mehrere dieser zugeordnete Behandlungskammern, in welche die zu beschichtenden Substrate mittels einer in der Transferkammer angeordneten Handlingseinrichtung ein- bzw. ausbringbar sind.

Zum Beschichten von Substraten durch ein bei Unterdruckbedingungen ablaufendes Beschichtungsverfahren sind unterschiedliche, entsprechend den erforderlichen Behandlungsstationen der Substrate ausgebildete Anlagentypen bekannt. Je nach gewünschtem Beschichtungsverfahren, z. B. einem Sputterverfahren oder einem Aufdampfverfahren und in Abhängigkeit des auf dem Substrat abzuscheidenden Schichtensystems werden unterschiedliche Vakuumbehandlungsanlagetypen eingesetzt. So werden z. B. aus mehreren Einzelschichten bestehende Schichtensysteme dadurch auf dem Substrat hergestellt, daß das Substrat nacheinander einzelne Beschichtungsstationen durchläuft, wobei in jeder Beschichtungsstation eine spezifische Einzelschicht auf dem Substrat abgeschieden wird. Weitere Behandlungsstationen sind dann erforderlich, wenn das Substrat zusätzlich einer Wärmebehandlung zu unterziehen ist bzw. die Substratoberfläche z. B. durch einen Plasmaätzprozeß vor- bzw. nachzubehandeln ist. Die Anordnung der einzelnen Behandlungsstationen erfolgt in bekannter Weise entweder in Clusterformation bzw. als Inline-Anlage. Bei den sogenannten Inline-Anlagen sind die einzelnen Behandlungsstationen hintereinander angeordnet und das Substrat wird zur Durchführung der einzelnen Behandlungsschritte sukzessive durch diese Behandlungsstationen transportiert. Diese Anlagen haben den Vorteil, daß sie sich in einfacher Weise in den Ablauf von der Vakuumbehandlung vorgelagerten bzw. nachgelagerten Bearbeitungsverfahren integrieren lassen. Bei den vorgenannten Cluster-Anlagen sind die einzelnen Behandlungskammern im wesentlichen peripher zu einer zentralen Handlingskammer angeordnet, in welcher eine Handlingsvorrichtung vorgesehen ist, mittels welcher die Substrate zwischen den einzelnen Behandlungskammern transportiert werden.

Der wesentliche Vorteil von Cluster-Anlagen besteht darin, daß diese kompakt, platzsparend aufgebaut sind. Ein Nachteil dieser Cluster-Vakuumbehandlungsanlagen ist, daß die zu behandelnden Substrate nur im sogenannten Batch-Betrieb zu bearbeiten sind. Ein kontinuierliches durchschleusen, wie bei Inline-Vakuumbehandlungsanlagen möglich, ist bei Cluster-Anlagen in der Regel nicht möglich. So werden bei Cluster-Anlagen eine Mindestanzahl von zu behandelnden Substraten geschlossen in eine der Behandlungsstationen eingebracht und nach erfolgter Bearbeitung aller Substrate gemeinsam aus der Cluster-Vakuumbehandlungsanlage heraustransportiert.

Aufgabe der vorliegenden Erfindung ist es, eine Vakuumbehandlungsanlage zu schaffen, mittels welcher eine Bearbeitung von Substraten durch Vakuumprozesse möglich ist, wobei der Prozeßablauf sich vorteilhaft in bestehende Produktionslinien integrieren läßt und eine platzsparende, Bauform aufweist. Weiterhin soll eine Verwendungsmöglichkeit für diese Vakuumbehandlungsanlage sowie ein Verfahren zum Beschichten von Werkstücken in dieser Vakuumbehandlungsanlage angegeben werden.

Die oben genannten Aufgaben werden erfindungsgemäß gelöst mit einer Vakuumbehandlungsanlage gemäß den Merkmalen des Patentanspruchs 1, einer Verwendung dieser Vakuumbehandlungsanlage gemäß den Merkmalen des Patentanspruchs 6 und den erfindungsgemäßen Verfahrensmerkmalen des Patentanspruchs 8.

Die erfindungsgemäße Vakuumbehandlungsanlage besteht im wesentlichen aus einer Transferkammer sowie mehreren peripher zur Transferkammer angeordneten und mit dieser jeweils über gemeinsame Öffnungen zum Ein- und Ausschleusen der Substrate verbundenen Behandlungskammern. In der Transferkammer ist eine Handlingseinrichtung vorgesehen, mittels welcher die Substrate zwischen den Behandlungskammern weitertransportiert werden. Hierzu weist die Handlingseinrichtung mindestens einen Substrathalter auf, mittels welchem die zu transportierenden Substrate gehalten werden. Eine gleichmäßige Behandlung der Substrate innerhalb der einzelnen Behandlungskammern wird dadurch gewährleistet, daß der Substrathalter ein schwenk- und/oder rotierbares Halteteil aufweist, an welchem das Substrat befestigt ist und mit welchem das in der jeweiligen Behandlungskammer befindliche Substrat während der Bearbeitung schwenk- und/oder rotierbar ist.

Weiterhin weist die erfindungsgemäße Vakuumbehandlungsanlage mindestens eine Behandlungskammer auf, die eine mit einem Deckel verschließbare Außenöffnung aufweist. Durch diese Außenöffnung werden die zu beschichtenden Substrate in die Vakuumbehandlungsanlage eingebracht bzw. die beschichteten Substrate aus dieser herausgebracht. Der mit der Erfindung erzielte Vorteil besteht insbesondere darin, daß die Vakuumbehandlungsanlage kontinuierlich mit den zu beschichtenden Substraten bestückt werden kann, diese anschließend dem Vakuumbehandlungsprozeß unterworfen werden können, um anschließend ebenso kontinuierlich aus der Anlage entnommen zu werden. Gleichzeitig weist die erfindungsgemäße Vakuumbehandlungsanlage eine kompakte Bauweise auf, die es vorteilhaft ermöglicht, diese in bestehende Fertigungsprozeßanlagen zu integrieren. Weiterhin wird durch die Halterung der zu beschichtenden Substrate an einem schwenk- und/oder rotierbaren Halteteil gewährleistet, daß die Substrate in den einzelnen Behandlungskammern den auf die Substrate einwirkenden Bearbeitungsprozessen gleichmäßig ausgesetzt werden. Hierdurch wird vermieden, daß die auf einem zu beschichtenden Substrat z. B. abzuscheidenden Schichten auf verschiedenen Stellen der Substratoberfläche wegen ihrer unterschiedlichen Ausrichtung zur Beschichtungsquelle unterschiedlich stark aufwachsen. Eine Abhängigkeit der Schichtdicke von der Substratform wird dadurch vorteilhaft vermieden.

Zum Beschichten von Substraten wird vorgeschlagen, in mindestens eine der Behandlungskammern eine Vakuumbeschichtungseinrichtung, vorzugsweise eine Vakuumverdampfereinrichtung anzuordnen. Zum Beschichten der Substrate wird in der Vakuumverdampfereinrichtung das zu verdampfende und abzuscheidende Material durch Wärmezufuhr geschmolzen bzw. verdampft und die Substrate in die Materialwolke zum Niederschlag des verdampften Materials auf den Substratoberflächen eingebracht.

Die erfindungsgemäße Vakuumbehandlungsanlage eignet sich vorteilhaft dazu, harte, dünne Schichten mittels eines Vakuumverdampferverfahrens auf Werkstücken gleichmäßig abzuscheiden. Hierzu werden die zu beschichtenden Werkstücke zunächst in einer ersten Behandlungskammer, in welcher eine Heizung angeordnet ist, auf eine ausreichend hohe Temperatur, vorzugsweise > 800°C erwärmt und im erwärmten Zustand mittels der Handlingseinrichtung in eine zweite, die Verdampfereinrichtung aufweisende Behandlungskammer überführt. Die harten, dünnen Schichten bestehen z. B. aus metallischen Legierungen des Typs MCrAlY, wobei die Legierungskomponente M, wie im Anspruch 5 angegeben, mindestens aus einem der Stoffe Nickel, Kobalt oder Eisen bzw. eine Anteile der Stoffe Nickel, Kobalt oder Eisen aufweisenden Legierung besteht. Zum Einschmelzen des Verdampfungsgutes, welches aus einer Basislegierung der vorgenannten Zusammensetzung besteht, wird die Verwendung einer bekannten Elektronenstrahlverdampferquelle vorgeschlagen. Hierzu wird der Verdampferquelle aus einem Magazin das Schmelzgut vorzugsweise in Stangenform zugeführt.

Eine erfindungsgemäße Vakuumbehandlungsanlage eignet sich in vorteilhafter Weise zur Herstellung harter Schichten auf solchen Werkstücken, welche zum Einsatz in Turbinenanlagen vorgesehen sind. Insbesondere können mit dieser Vakuumbehandlungsanlage harte, korrosionsbeständige metallische und/oder keramische Wärmedämmschichten auf Turbinenschaufeln, vorzugsweise auf in Gasturbinenanlagen einzusetzende Turbinenschaufeln hergestellt werden. Prinzipiell ist der Einsatzbereich der unter Verwendung einer erfindungsgemäßen Vakuumbehandlungsanlage beschichteten Turbinenschaufeln jedoch nicht auf Gasturbinenanlagen beschränkt.

Ein erfindungsgemäßes Verfahren zur Herstellung von verschleißresistenten, harten Schichten auf Substraten mittels der erfindungsgemäßen Vakuumbehandlungsanlage umfaßt mehrere, nachfolgend genannte Verfahrensschritte.

Zunächst ist das zu beschichtende Substrat vom Außenraum in eine erste Behandlungskammer, welche eine Außenöffnung aufweist, einzubringen und auf dem in diese Behandlungskammer hineinragenden Substrathalter zu fixieren (siehe Teilmerkmal a) des Anspruchs 8). Die der Außenöffnung gegenüberliegende Innenöffnung der Beladekammer wird während des Beladevorganges von einer Verschlußplatte vakuumdicht von der Transferkammer verschlossen. Anschließend wird die Beladekammer zum Druckausgleich auf den in der Transferkammer eingestellten Unterdruck evakuiert. Zum Überführen des oder der zu beschichtenden Substrate in eine erste Behandlungskammer wird durch Betätigen der Handlingseinrichtung die Verschlußplatte gemeinsam mit den Substraten aus der Verschlußposition in die zugeordnete Offen-Position verfahren (siehe Teilmerkmal c)). Hierzu weist die Handlingseinrichtung eine im Vakuumkammerdeckel und/oder in der Vakuumkammerbodenplatte der Transferkammer gelagerte Welle oder Schraubenspindel auf, welche bei Drehung dieser zugeordnete Operatoren die mit diesen Operatoren verbundenen Verschlußplatten von einer radial inneren Öffnungs- zu einer radial äußeren Schließposition bzw. von der Schließposition zur Öffnungsposition verfährt. Die Operatoren bestehen z. B. aus Hebeltrieben oder teleskopierbaren Auslegern, die einerends an einer auf der Spindel laufenden Spindelmutter angelenkt sind und andernends mit den Verschlußplatten verbunden sind. Die Verschlußplatten weisen auf ihren jeweils den Behandlungskammern zugewandten Seitenflächen Substrathalter oder -greifer auf.

Durch Drehung der Handlingseinrichtung um einen Drehwinkel von z. B. 90° oder 180° wird das Substrat mit der Verschlußplatte aus der Offen-Position der ersten Behandlungskammer in die der zweiten Behandlungskammer zugeordneten Offen-Position überführt. Durch Betätigen des Spindel- bzw. Wellenantriebes der Handlingseinrichtung werden die Substrate aus dieser Offen-Position in die zugeordnete Verschlußposition überführt, wobei das bzw. die Substrate in die zweite Behandlungskammer eingebracht werden und diese gleichzeitig durch die Verschlußplatte vakuumdicht von der Transferkammer getrennt wird. Zum Beschichten von Substraten mit harten, dünnen, korrosionsresistiven Schichten sind die Substrate während des gesamten Beschichtungsvorganges auf eine Mindesttemperatur zu erwärmen. Hierzu weist die erste Behandlungskammer eine Heizung auf, mit welcher die Substrate auf die erforderliche Prozeßtemperatur von z. B. mindestens 800°C, vorzugsweise mindestens 1000°C erwärmt werden.

Das erwärmte Substrat wird mittels der Handlingsvorrichtung in analoger Weise wie der Transport von der Belade- zur zweiten Behandlungskammer anschließend von der zweiten Behandlungskammer einer dritten Behandlungskammer zugeführt. In dieser Vakuumbehandlungskammer befindet sich eine Vakuumbeschichtungsquelle, vorzugsweise eine Verdampferquelle, mittels der das auf dem Substrat abzuscheidende Material verdampft wird. Die vorzugsweise in der Materialdampfwolke während des Beschichtungsprozesses rotierenden bzw. verschwenkten Substrate werden dadurch weitestgehend unabhängig von ihrer räumlichen Form gleichmäßig beschichtet. Zum Auftragen harter, dünner Schichten hat sich als vorteilhaft erwiesen, das Schmelzgut mittels eines bekannten Elektronenstrahlverdampfers auf die Verdampfungstemperatur zu erwärmen. Da das zu verdampfende Schmelzgut eine hohe Schmelztemperatur besitzt, wird durch den lokal auf dem Schmelzgut auftreffenden Elektronenstrahl die notwendige Schmelz- bzw. Verdampfungstemperatur erzielt.

Nach Beendigung der Beschichtungsphase wird das Substrat über die zugeordnete Offen-Position der dritten Behandlungskammer durch anschließendes Drehen der Handlingseinrichtung um z. B. einen Drehwinkel von 90° in die Offen-Position der benachbarten Behandlungskammer gebracht. Das Substrat wird aus dieser Offen-Position in die zugeordnete Verschlußposition dieser eine verschließbare Außenöffnung aufweisende Behandlungskammer überführt, wobei das Innere der Behandlungskammer durch die Verschlußplatte vakuumdicht von der Transferkammer getrennt wird. Nach Belüften der als Be- bzw. Entladekammer ausgebildeten ersten Behandlungskammer werden die beschichteten Substrate durch die Außenöffnung der Be-/Entladekammer z. B. mittels eines Roboterhandling entnommen.

Die Anzahl der Behandlungskammern kann vorteilhaft in Abhängigkeit der vorgesehenen Vakuumbehandlungsprozesse gewählt werden. Vorzugsweise werden die Behandlungskammern äquidistant zueinander und peripher zur Transferkammer angeordnet. Zum Transport der Substrate durch Drehung der Handlingseinrichtung zwischen benachbarten Offen-Positionen wird dann ein Winkel α = 360°/n durchfahren, wobei n der Anzahl der Behandlungsstationen entspricht. Bei einer erfindungsgemäßen Vakuumbehandlungsanlage können die Behandlungskammern auch in nicht äquidistantem Abstand zueinander angeordnet werden, wodurch sich für den Transportwinkel zwischen zwei Behandlungskammern unterschiedliche Werte für α ergeben.

Die erfindungsgemäße Vakuumbehandlungsanlage wird nachfolgend anhand eines besonders bevorzugten und in Zeichnungen dargestellten Ausführungsbeispiels näher erläutert. Es zeigen:
- Fig. 1: eine erfindungsgemäße Vakuumbehandlungsanlage in geschnittener Aufsichtdarstellung;
- Fig. 2: eine Schnittansicht der in Fig. 1 dargestellten Vakuumbehandlungsanlage entlang der Schnittlinie B-B';
- Fig. 3: eine Schnittansicht der in Fig. 1 dargestellten Vakuumbehandlungsanlage entlang der Schnittlinie A-A';
- Fig. 4: eine teilweise geschnittene Seitenansicht der in Fig. 1 dargestellten Vakuumbehandlungsanlage entlang der Schnittlinie E-E'.

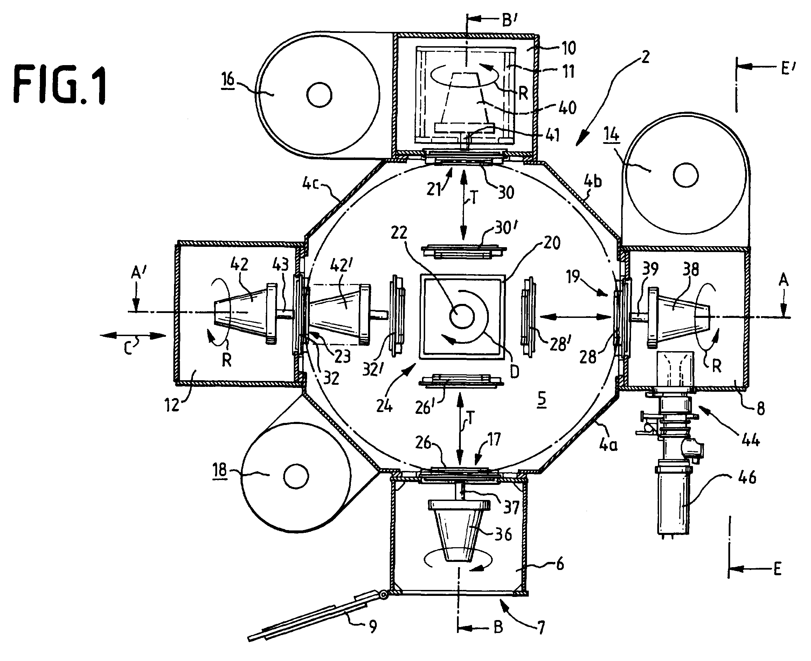

In der Fig. 1 ist eine Vakuumbehandlungsanlage 2 dargestellt, welche insgesamt vier Behandlungskammern 6,8,10,12 aufweist. Diese Behandlungskammern 6,8,10,12 sind peripher zu einer Transferkammer 5 angeordnet, wobei die Transferkammer 5 einen oktaedrischen Querschnitt aufweist, an dessen übernächsten Oktaederseiten jeweils die einzelnen Behandlungskammern 6,8,10,12 angeflanscht sind.

Über Innenöffnungen 17,19,21,23 sind die Behandlungskammern 6,8,10,12 jeweils mit dem Inneren der Transferkammer 5 verbunden. Die einzelnen Behandlungskammern 6,8,10,12 unterscheiden sich in ihrer Funktion für einen vollständigen Behandlungszyklusses wie folgt:
- Behandlungskammer 6 dient als Be- und Entladekammer der Substrate 36,
- Behandlungskammer 12 dient zur Vor- und/oder Nachbehandlung der Substrate 42,42',
- die Behandlungskammer 10 ist als Heizkammer ausgebildet, in welcher die Substrate 40 auf eine vorbestimmte Temperatur erwärmbar sind und
- Behandlungskammer 8 ist als Beschichtungskammer ausgebildet, in welcher die Substrate 38 unter Verwendung einer Beschichtungsquelle 65 beschichtet werden.

Die einzelnen Behandlungskammern 6,8,10,12 sowie die Transferkammer 5 sind über Vakuumpumpen 14,16,18 auf Unterdruck abpumpbar. In der Transferkammer 5 ist im wesentlichen zentrisch zu den Behandlungskammern 6,8,10,12 eine Handlingseinrichtung 24 (siehe Fig. 1) angeordnet, welche zum Transport der Substrate 36,38,40,42,42' zwischen den Behandlungskammern 6,8,10,12 dient. Die Handlingseinrichtung 24 besteht aus einem Drehgestell 20, welches drehbar um eine Drehachse 22 gelagert ist. Das Drehgestell 20 wird von einem Motor 60 über ein Getriebe 61, das über eine Drehantriebswelle 50 mit dem Drehgestell 20 gekoppelt ist, angetrieben. An dem Drehgestell 20 sind entsprechend der Anzahl der Behandlungskammern 6,8,10,12 insgesamt vier Verschlußplatten 26,28,30,32 angeordnet. Diese Verschlußplatten 26,28,30,32 dienen zum Verschließen der Behandlungskammeröffnungen 17,19,21,23. Hierzu sind die Verschlußplatten 26,28,30,32 jeweils an einem Operator, der als Zug-/Druckstrebe 48a,b; 49a,b;50a,b;51a,b ausgebildet ist, angelegt. Die Zug-/Druckstreben 48a,b,49a,b;50a,b;51a,b sind einerends an dem Drehgestell 20 angelenkt und halten andernends die mit diesem verbundenen Verschlußplatten 28,28,30,32 in senkrechter Ausrichtung. Zum Verschließen der Behandlungskammeröffnungen 17,19,21,23 werden die Verschlußplatten 26,28, 30,32 von einer radial inneren Offen-Position 26',28',30',32' zu einer radial äußeren Schließposition bewegt, wobei die mit der Antriebswelle 57 direkt oder über eine Schraubenspindel mit dieser zusammenwirkenden Operatoren als Hebeltriebe oder teleskopierbare Ausleger ausgebildet sind.

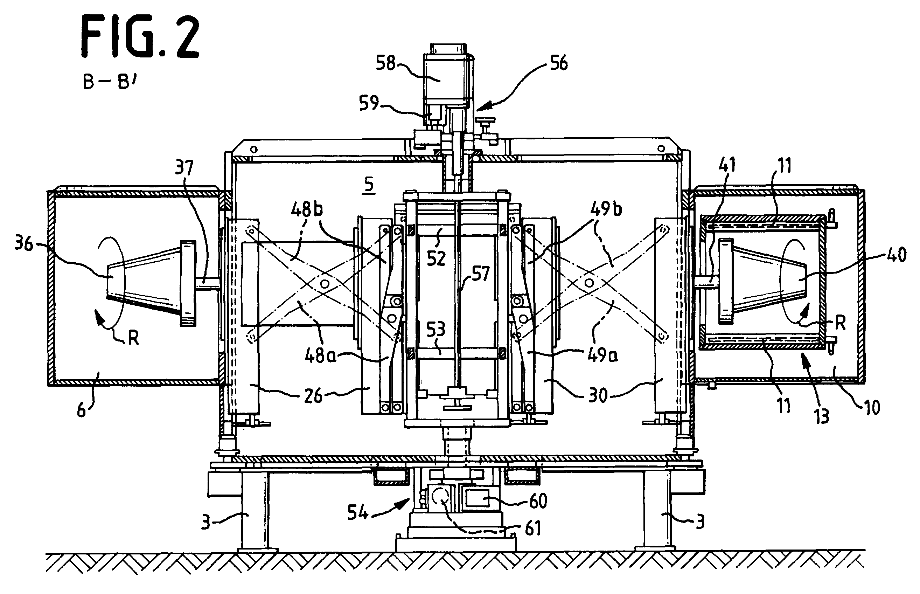

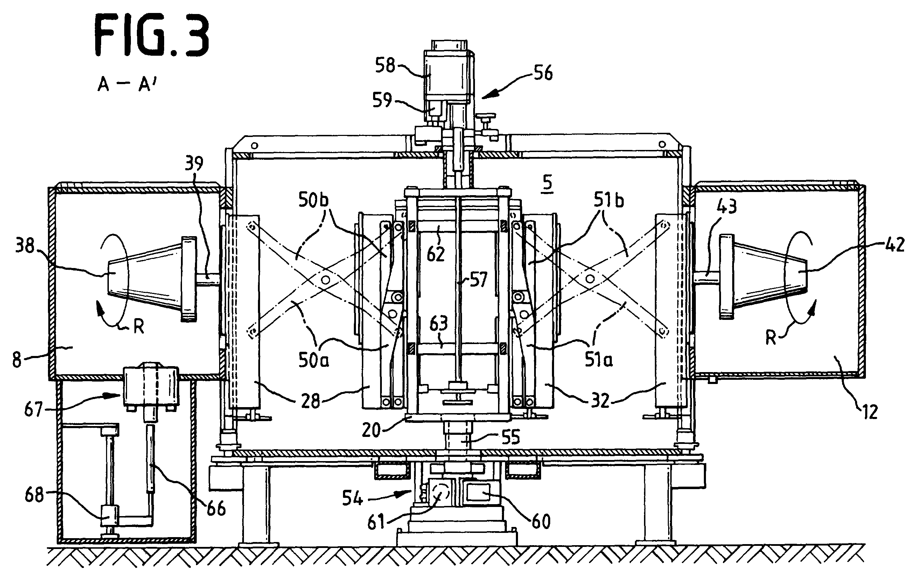

Die Verschlußplatten 26,28,30,32 weisen jeweils auf ihrer den Behandlungskammern 6,8,10,12 zugewandten Seitenflächen Substrathalter oder -greifer auf, mit welchen die Substrate 36,38,40,42,42' festgehalten und transportiert werden. Die Substrathalter 37,39,41,43 sind schwenkbar an den einzelnen Verschlußplatten 26,28,30,32 angelenkt. Mittels eines in den Figuren nicht dargestellten Antriebsmechanismusses sind die Substrate 36,38,40,42,42' insbesondere während der einzelnen Behandlungsprozesse in den Behandlungskammern 8,10,12 (siehe Fig. 2, Fig. 3) verschwenk- bzw. rotierbar. Durch diese Maßnahme erfolgt die Einwirkung von z. B. Wärme bzw. auf den Substraten 36,38,40,42,42' abzuscheidendes Beschichtungsmaterial auch bei unregelmäßige Oberflächen aufweisenden Substraten 36,38,40,42 über deren gesamte Ausdehnung gleichmäßig.

Zum Vakuumbeschichten eines Substratteils wird dieses einzeln oder zusammen mit anderen Substratteilen an dem in die Be- bzw. Entladekammer 6 hineinragenden Substrathalter 37 befestigt. Nach Verschließen des Deckels 9 wird die Be- bzw. Entladekammer 6 auf den in der Transferkammer 5 herrschenden Unterdruck abgepumpt. Durch Betätigen der Handlingseinrichtung 24 wird das Substrat 36 und die Verschlußplatte 26 zunächst in die zugeordnete Offen-Position 26' überführt. Synchron hierzu werden die übrigen Substrate 38,40,42 zusammen mit den zugeordneten Verschlußplatten 28,30,32 aus der jeweiligen Verschlußposition in die den Behandlungskammern 8,10,12 zugeordneten Offen-Positionen 28',30',32' überführt. Zum Weitertransport der Substrate 36,38,40,42 in die nächste Behandlungskammer wird der Transportantrieb 54 (siehe Fig. 2) aktiviert und das Drehgestell 20 zusammen mit der Handlingseinrichtung 24 und den Substraten 36,38,40,42 in Transportrichtung D weitertransportiert.

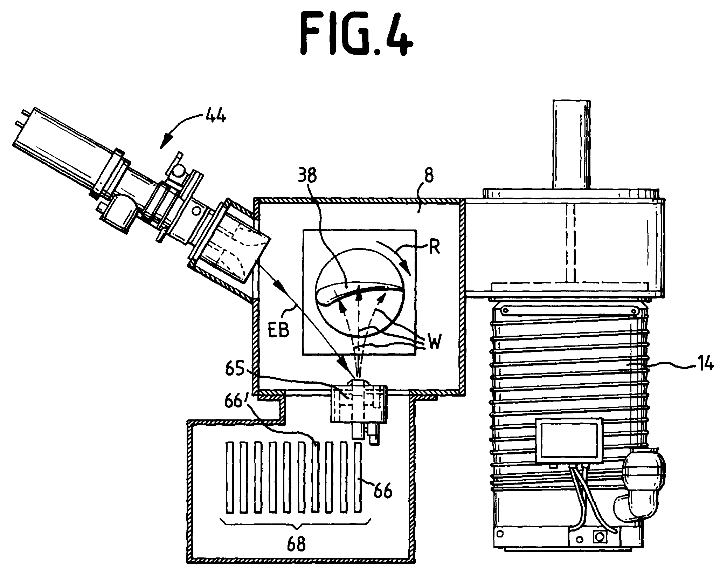

Zum Beschichten von Substraten mit harten, dünnen Schichten, welche durch Aufdampfen aufgetragen werden, ist es erforderlich, die Substrate während des gesamten Beschichtungsverfahrens auf eine Temperatur > 800°C, vorzugsweise > 1000°C zu halten. Hierzu wird das zu erwärmende Substrat zunächst von der Be-/Entladekammer 6 durch eine 180°-Drehung gegenüber der Heizkammer 10 positioniert und von der Offen-Position 30 durch Betätigen des Spindelantriebs 56 in die zugeordnete Verschlußposition verfahren. Mit der in der Heizkammer 10 vorgesehenen Heizung 11 wird das Substrat 40 unter gleichzeitigem Drehen in die Drehrichtung R gleichmäßig auf die vorgewählte Solltemperatur erwärmt. Nach Abschluß der Erwärmungsphase wird das Substrat 40 radial in die Offen-Position 30' verfahren und durch eine 90°-Rotation des Drehgestells 20 um die Drehachse 22 und einer radialen Transportbewegung in die Beschichtungskammer 8 überführt. In der Beschichtungskammer 8 wird das Substrat 38 dann in eine Materialwolke W, welche z. B. mittels einer herkömmlichen Verdampferquelle 65 erzeugt wird, zum Niederschlag des verdampften Schmelzgutes 66 auf dem Substrat 38 eingebracht. Um eine gleichmäßige, homogene Beschichtung des Substrats 38 unabhängig vom Niederschlagsort auf dem Substrat 38 zu bewirken, rotiert das Substrat 38 um die Achse des Substrathalters 39 in Drehrichtung R (siehe Fig. 4). Bei der Beschichtungsquelle 65 handelt es sich um eine Elektronenstrahlverdampferquellenanordnung, welche eine herkömmliche Elektronenstrahlkanone 44 und den Verdampfer 65 umfaßt. Das zu verdampfende Schmelzgut 66 wird aus einem Schmelzgutmagazin 68 (siehe Fig. 4) dem Verdampfer 65 in Stangenform zugeführt. Der von der Elektronenstrahlkanone 44 ausgesandte Elektronenstrahl EB wird mit einer, Energie von z. B. 35 keV auf die aus dem Verdampfer 65 herausragende, freie Stirnfläche der Schmelzgutstange 66 durch ein in den Figuren nicht dargestelltes, von einer Spule erzeugtes Magnetfeld gelenkt. Das Schmelzgut 66 schmilzt an der Auftreffstelle des Elektronenstrahls EB auf und verdampft unter Bildung einer Materialwolke W, welche sich auf der Substratoberfläche des Substrats 38 niederschlägt.

Nach abgeschlossener Beschichtungsphase des Substrats 38 wird dieses entweder durch einen weiteren 90°-Transportzyklus der Be-/Entladekammer 6 zum Ausschleusen aus der Vakuumbehandlungsanlage 2 transportiert oder in der Behandlungskammer 12 nachbehandelt. Als Nachbehandlungsprozeß kann ein nachträgliches Oxydieren der beschichteten Substratoberfläche durch Einlaß eines reaktiven Oxydgases erfolgen bzw. das Substrat auch einer weiteren Wärmebehandlung ausgesetzt werden.

### Bezugszeichenliste

- 2: Vakuumbehandlungsanlage
- 3: Gestell
- 4a, 4b, 4c: Kammerwand
- 5: Transferkammer
- 6: Be- und Entladekammer, Behandlungskammer
- 7: Kammeröffnung / Außenöffnung
- 8: Beschichtungskammer, Behandlungskammer
- 9: Deckel
- 10: Heizkammer, Behandlungskammer
- 11: Heizung
- 12: Vor- bzw. Nachbehandlungskammer, Behandlungskammer
- 13: Heizvorrichtung
- 14: Vakuumpumpe
- 15: Abpumpflansch
- 16: Vakuumpumpe
- 17: Innenöffnung
- 18: Vakuumpumpe
- 19: Innenöffnung
- 20: Drehgestell
- 21: Innenöffnung
- 22: Drehachse
- 23: Innenöffnung
- 24: Handlingseinrichtung
- 26: Verschlußplatte
- 26': Offen-Position
- 28: Verschlußplatte
- 28': Offen-Position
- 30: Verschlußplatte
- 30': Offen-Position
- 32: Verschlußplatte
- 32': Offen-Position
- 36: Substrat/Turbinenschaufel
- 37: Substrathalter
- 38: Substrat, Turbinenschaufel
- 39: Substrathalter
- 40: Substrat, Turbinenschaufel
- 41: Substrathalter
- 42, 42': Substrat, Turbinenschaufel
- 43: Substrathalter
- 44: Elektronenstrahlkanone
- 46: Elektronenstrahlkanone
- 48a, 48b: Zug-/Druckstrebe
- 49a, 49b: Zug-/Druckstrebe
- 50a, 50b: Zug-/Druckstrebe
- 51a, 51b: Zug-/Druckstrebe
- 52: Arm
- 53: Arm
- 54: Transportantrieb
- 55: Drehantriebswelle
- 56: Spindelantriebseinheit
- 57: Spindel/Antriebswelle
- 58: Motor
- 59: Getriebe
- 60: Motor
- 61: Getriebe
- 62: Arm
- 63: Arm
- 65: Verdampferquelle, Beschichtungsquelle
- 66: Schmelzgut
- 67: Materialvorschubeinrichtung
- 68: Schmelzgutmagazin
- 70: Schmelz
- R: Substratdrehrichtung
- EB: Elektronenstrahl
- T: Verschiebestrecke
- D: Transportrichtung
- W: Bedampfungswolke

## Patentansprüche

1. Vakuumbehandlungsanlage zum Aufbringen dünner Schichten auf Substrate (36,38,40,42) mit einer Transferkammer (5) und mehreren an dieser peripher angeordneten und mit dieser jeweils über eine gemeinsame Öffnung (27,29,31,33) zum Ein- und Ausschleusen der Substrate (36,38,40,42) verbundenen Behandlungskammern (6,8,10,12) und mit einer Handlingseinrichtung (24) zum Transport der Substrate (36,38,40,42) zwischen den Behandlungskammern (6,8,10,12), wobei die Handlingseinrichtung (24) mindestens einen Substrathalter (37,39,41,43) mit einem schwenk- und/oder rotierbaren Halteteil zur Aufnahme der Substrate (36,38,40,42) aufweist, mittels welchen die Substrate (36,38,40,42) in den Behandlungskammern (6,8,10,12) schwenk- und/oder rotierbar sind.

2. Vakuumbehandlungsanlage nach Anspruch 1, **dadurch gekennzeichnet**, daß mindestens eine Behandlungskammer (6) eine mit einem Deckel (9) verschließbare Außenöffnung (7) aufweist, durch welche die Substrate (36,38,40,42) in die Vakuumbehandlungsanlage ein- und/oder ausbringbar sind.

3. Vakuumbehandlungsanlage nach Anspruch 1, **dadurch gekennzeichnet**, daß mindestens eine Behandlungskammer (10) eine Heizung (11) aufweist, mittels welcher die Substrate (36,38, 40,42) erwärmbar sind.

4. Vakuumbehandlungsanlage nach Anspruch 1, **dadurch gekennzeichnet**, daß mindestens eine Behandlungskammer (6) eine Vakuumbeschichtungseinrichtung, vorzugsweise eine Vakuumverdampfereinrichtung (44,46) aufweist, mittels welcher die Substrate (36,38,40,42) mit einem zu verdampfenden Material beschichtbar sind.

5. Vakuumbehandlungsanlage nach Anspruch 4, **dadurch gekennzeichnet**, daß das zu verdampfende Materialgut (66) aus einer Basislegierung der Zusammensetzung MCrAlY besteht, wobei der Basislegierungsbestandteil M mindestens einen der Stoffe Nickel, Kobalt oder Eisen oder eine Anteile der Stoffe Nickel, Kobalt oder Eisen aufweisende Legierung aufweist.

6. Verwendung einer Vakuumbehandlungsanlage nach mindestens einem der Ansprüche 1 bis 5 zum Beschichten von Werkstücken mit harten Schichten, bestehend aus einer MCrAlY-Basislegierung, wobei der Basislegierungbestandteil M mindestens einen der Stoffe Nickel, Kobalt oder Eisen enthält.

7. Verwendung einer Vakuumbehandlungsanlage zur Herstellung harter Schichten insbesondere nach Anspruch 6 auf zum Einsatz in Turbinenanlagen vorgesehenen Werkstücken (36,38,40,42), insbesondere auf Turbinenschaufeln (36,38,40,42), vorzugsweise auf in Gasturbinenanlagen zu verwendende Turbinenschaufeln.

8. Verfahren zur Herstellung von verschleißresistenten, harten Schichten auf Substraten (36,38,40,42) mittels einer Vakuumbehandlungsanlage nach mindestens einem der Ansprüche 1 bis 6, welches folgende Verfahrensschritte aufweist:
a) Einbringen des zu beschichtenden Substrats (36) vom Außenraum (1) in eine erste Behandlungskammer (6), durch deren Außenöffnung (7) und Positionieren des Substrats (36) auf einem in die Behandlungskammer (37) hineinragenden Substrathalter (37);
b) Evakuieren der Behandlungskammer (6) zur Herstellung eines Druckausgleichs zwischen der Unterdruck aufweisenden Transferkammer (5) und der Behandlungskammer (37);
c) Überführen des Substrats (36) mit der zugeordneten Verschlußplatte (26) aus der der Behandlungskammer (37) zugeordneten Verschlußposition in die zugeordnete Offen-Position (26') durch Betätigen der Handlingseinrichtung (24);
d) Überführung des Substrats (36) mit der Verschlußplatte (26) aus der Offen-Position (26') in die der Behandlungskammer (12) zugeordnete Offen-Position (30') durch eine Drehung der Handlingseinrichtung (24) um einen Drehwinkel von 180°;
e) Überführung des Substrats (36) mit der zugeordneten Verschlußplatte aus der Offen-Position (30') in die zugeordnete Verschlußposition, wodurch das Substrat (36) in die eine Heizung aufweisende Behandlungskammer (10) transportiert wird;
f) Erwärmen des Substrats (36) mittels von der Heizung (11) in der Behandlungskammer (10) abgegebenen Wärmeenergie auf eine Temperatur > 800°C, vorzugsweise > 1000°C;
g) Überführung des erwärmten Substrats (36) aus der Behandlungskammer (10) gemeinsam mit der zugeordneten Verschlußplatte in die Offen-Position (30');
h) Transportieren des Substrats (36) durch Drehung der Handlingseinrichtung (24) um eine Drehwinkel von 90° in die der Behandlungskammer (8) zugeordnete Offen-Position (28');
i) Transportieren des Substrats (36) mit der zugeordneten Verschlußplatte aus der Offen-Position (28') in die zugeordnete Verschlußposition, wodurch das Substrat (36) in die eine Vakuumbeschichtungsquelle aufweisende Behandlungskammer (8) transportiert wird;
j) Beschichten des Substrats mit dem von der Beschichtungsquelle (44) durch Verdampfen, vorzugsweise Elektronenstrahlverdampfen erzeugten Materialwolke aus dem verdampften Schmelzgut;
k) Transportieren des beschichteten Substrats (36) mit der zugeordneten Verschlußplatte in die Offen-Position (28');
l) Transportieren des beschichteten Substrats mit der zugeordneten Verschlußplatte durch Drehung der Handlingseinrichtung (24) um einen Drehwinkel von 90° in die Offen-Position (26');
m) Transportieren des beschichteten Substrats (36) mit der zugeordneten Verschlußplatte in die Verschlußposition der Behandlungskammer (7);
n) Belüften der Behandlungskammer (6) und Entnahme des beschichteten Substrats (36) durch die Außenöffnung (7) der Behandlungskammer (6).
